## Europäisches Patentamt
## European Patent Office
## Office européen des brevets

(19)

(11) Publication number: **0 163 082**
**B1**

(12)

# EUROPEAN PATENT SPECIFICATION

(45) Date of publication of patent specification: **23.11.88**

(51) Int. Cl.⁴: **H 01 L 23/04, H 01 L 23/48**

(21) Application number: **85104420.6**

(22) Date of filing: **11.04.85**

(54) **Packaged integrated circuit chip.**

(30) Priority: **02.05.84 US 606309**

(43) Date of publication of application:
**04.12.85 Bulletin 85/49**

(45) Publication of the grant of the patent:
**23.11.88 Bulletin 88/47**

(84) Designated Contracting States:
**AT BE DE FR GB IT NL**

(56) References cited:
**EP-A-0 023 165**
**DE-A-3 112 564**
**GB-A-2 027 990**
**GB-A-2 072 423**

(73) Proprietor: **GTE Products Corporation**
**100 West 10th Street**
**Wilmington, DE 19801 (US)**

(72) Inventor: **Gilderm, Thomas G., Jr.**
**1169 Fairview Drive**
**York, PA 17403 (US)**
Inventor: **O'Dean, Raymond D.**
**3620 Willow Road**
**Dover, PA 17315 (US)**

(74) Representative: **Patentanwälte Grünecker, Dr. Kinkeldey, Dr. Stockmair, Dr. Schumann, Jakob, Dr. Bezold, Meister, Hilgers, Dr. Meyer-Plath**
**Maximilianstrasse 58**
**D-8000 München 22 (DE)**

Courier Press, Leamington Spa, England.

## Description

This invention refers to a packaged IC chip as set forth in the preamble of claim 1. A packaged IC chip of this kind is known from GB—A—2 072 423.

In the known IC chip the lead frame means is formed by a plurality of spaced-apart leads which are inter-connected with each other by means of a ring, weakened areas connecting the leads to the ring. The lead frame means thus totally encircles the pad area on which the IC chip is disposed. In assembly of the packaged IC chip, the leads are to be bonded to conductive tracks formed on the insulating support, and the ring is then stripped away to separate the leads. The support is made of ceramic material and is closed by a cover, a ring of glass sealant being deposited over the central parts of the conductive tracks and the leads to affix the cover to the support and seal the IC chip from the environment.

This type of package of an IC chip requires a sophisticated preparation of the elements to be assembled. Firstly, the support from ceramic material must be provided with afore-mentioned conductive tracks. The leads must be inter-connected with each other by the ring. All leads must be bonded to the conductive tracks of the support in order to enable the ring to be removed for separating the leads. Special tools are required to properly fix the leads to the ring and to align the lead and ring structure to the conductive tracks. Additionally, the lead and ring structure must specifically be adapted to the particular IC chip mounted on the support. This is, in some instances, economical.

It is the object of the present invention to provide a packaged IC chip of the afore-mentioned kind which is easy to assemble.

This object is attained by the characterizing features of claim 1. Preferred embodiments of the invention are the subject matter of the dependent claims.

For the manufacture of packaged IC chips of the invention, preferably stamped lead frames are used because of its low cost having a plurality of leads which are inter-connected by rails cut or broken away after mounting of the frames. As the circuits on IC chips become more complex, a great number of leads per lead frame is required. This complicates the stamping operation. Stamping is carried out in progressive dyes requiring a number of stations where successive stamping operations are carried out. By the invention, the number of required stamping stations and cuts per lead frame can be reduced as the lead frame means is not made as an entire lead frame but is fabricated from a plurality of individual segments which can be fabricated from the same set of stamping tools. Thus, if two segments are used per lead frame, the number of stamping stations can be about halved and the number of cuts can be reduced even more. If four segments are used per lead frame, the number of stamping stations and cuts can be reduced at an even greater extent.

Furthermore, proper positioning is facilitated by the projections formed on the support as the leads are positioned by the slots defined between the projections.

The invention will now be explained with reference to the accompanying drawing.

Fig. 1 shows a lead frame segment after stamping.

Fig. 2 shows a strip of such lead frame segments.

Fig. 3 is a plan end view of a support for a lead frame.

Fig. 4 shows the support with three lead frame segments attached and the fourth ready for attachment.

Fig. 5 shows the support with all lead frame segments attached and the leads formed.

Figs. 6 and 7 are plan and end views of a cover for the support.

Fig. 8 shows the finished chip-containing lead frame package.

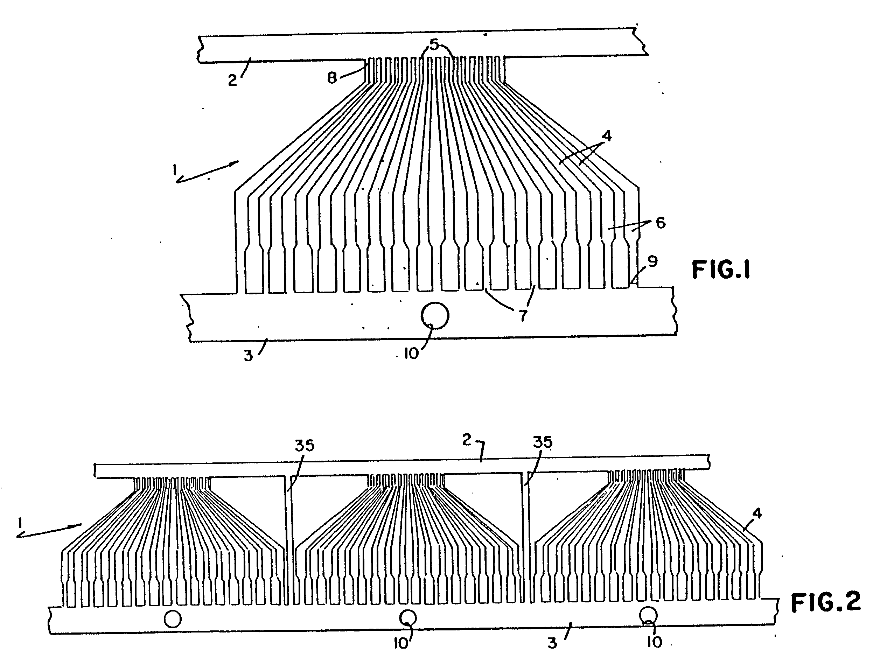

In one embodiment, substantially identical lead frame segments 1 were stamped from a long metal strip, as shown in Fig. 2. One such segment 1 is shown in Fig. 1. In one example, segments 1 are stamped from 0,25 mm copper alloy and are maintained in strip form by means of continuous rails 2 and 3, as shown in Fig. 2. Between segments 1, there are support bars 35 extending from rail 3 to rail 2. Each segment 1 comprises seventeen leads 4. The inner ends 5 of leads 4, which will be electrically conected to an IC chip, are about 0,23 mm wide and spaced about 0,23 mm apart. The widest parts 6 of leads 4 are inward from the outer ends 7 thereof and are 0,71 mm wide spaced 0,55 mm apart. Outer ends 7 are 0,46 mm wide spaced 0,81 mm apart. There are score lines 8 and 9 on leads 4 about 0,13 mm from rails 2 and 3. Rails 2 and 3 will later on be broken off at score lines 8 and 9. There are 1,57 mm diameter holes 10 in rail 3, which provide means for precise positioning of the lead frame segments during indexing of the copper strip during processing. Rails 2 and 3 are 1,6 mm and 2,54 mm wide, respectively. The distance between score lines 8 and 9 is 12,2 mm.

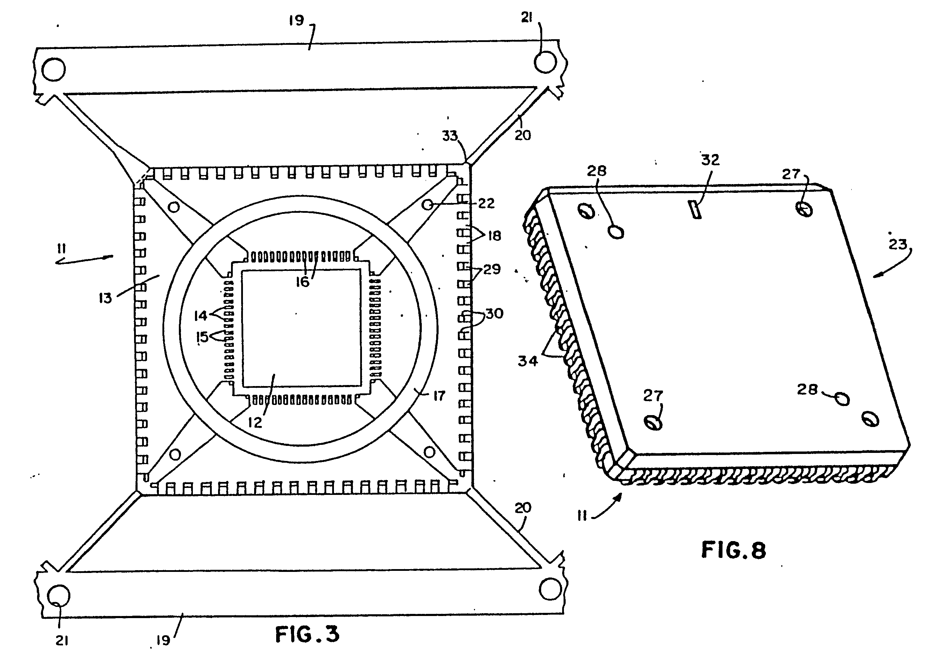

Support 11 for this example, shown in Fig. 3, is made of a high temperature thermoplastic material, specifically, a polyetherimide resin. In the center of support 11 is a recess 12 in which an IC chip will be disposed. Recess 12 is about 8,6 mm square and is recessed 0,2 mm below surface 13 of support 11. Surrounding recess 12 are 72 raised projections 14, eighteen per side. Projections 14 are about 0,18 mm wide by 0,63 mm long by 0,23 mm high. Spaces 15 between the projections are 0,28 mm wide. At assembly of segments 1 to support 11, narrow ends 5 of leads 4 lie on surface 13 in spaces 15 between projections 14. This provides means for accurate co-planar positioning of ends 5 in support 11. On the inner end of each projection 14 is another raised portion 16, measuring 0,18 mm wide by 0,25 mm long by 0,15 mm high. Raised portions 16 provide means for securing the leads in spaces 15 by, for example heating and slightly flowing plastic portions 16 over the leads. There is an encircling trough 17 outside the perimeter formed by all the projections 14.

At the periphery of support 11 there are 68 slots 18 in which parts 6 of leads 4 fit. Slots 18 are formed by projections 29 which are similar to projections 14 but bigger. Projections 29 are about 0,51 mm wide by 0,81 mm long by 0,23 mm high. Slots 18 are 0,76 mm wide. There are raised portions 30 on the inner ends of projections 29, similar to raised portions 16 on projections 14. Raised portions 30 are 0,51 mm wide by 0,25 mm long by 0,15 mm high.

In order to permit supports 11 to be processed in existing manufacturing equipment for chip-carrying lead frames, there are rails 19, compatible with said equipment, spaced from each side of support 11 and connected thereto by tie bars 20. Rails 19 are 0,25 mm thick by 3,43 mm wide and were 35,56 mm apart from each other. Holes 21 provide means for accurate positioning of the supports during indexing. There are four posts 22 on support 11 for accurate mating of support 11 with cover 23, which are made of the same plastic as support 11.

Cover 23 has a recess 24 to mate with recess 12, and has an additional recess 25 to accommodate projections 14. Cover 23 also has a trough 26 to mate with trough 17 and four holes 27 into which posts 22 fit. There are also two holes 28 connecting with trough 26. After assembly of cover 23 onto support 11, a sealant material is injected into holes 28 to fill troughs 17 and 26 in order to seal the IC chip from the environment.

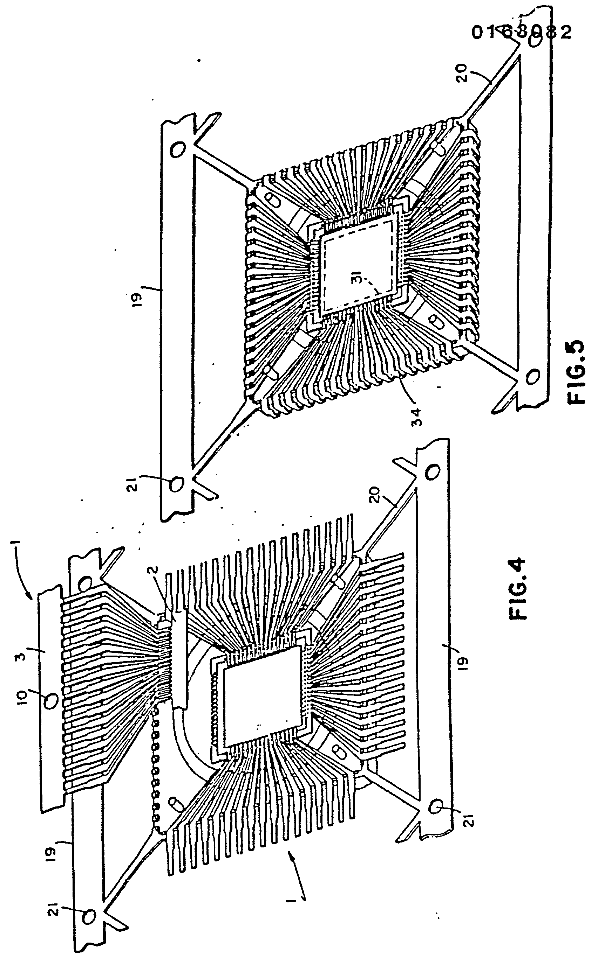

Assembly of the components proceeds as follows. Four lead frame segments 1, with rails 2 and 3 still attached, are placed on top of support 11, one at a time and one in each quadrant, as shown in Fig. 5. Each segment 1, with rails 2 and 3 still attached thereto but with rail 2 having been trimmed sufficiently to fit the space, as shown in Fig. 4, is carefully positioned so that ends 5 lay in spaces 15 and parts 6 lay in slots 18. Pressure is then applied to segment 1 to ensure that it is flush against surface 13 and then, maintaining the pressure, heat is applied to portions 16 and 30 to cause them to flow over, and secure in place, ends 5 and parts 6 of leads 4. Rails 2 and 3 are then broken off at score lines 8 and 9. This process is repeated for each lead frame segment 1. This construction ensures accurate positioning, with secure attachment, of all 68 leads with excellent co-planarity thereof.

Next, an IC chip 31, shown in dotted lines in Fig. 5, is conventionally attached in the pad area, recess 12, and is conventionally electrically connected to ends 5 of leads 4. The rail construction of support 11 permits this processing to be performed on existing chip-carrier lead frame processing equipment. An advantage of this invention is that the IC chip and package can now be tested for electrical characteristics, because all 68 leads are now electrically isolated, and repair of electrical connections can be made, if necessary. In the past, such repair could not be made because the leads were not electrically isolated until after packaging. The external ends of leads 4 can now be formed into a desired shape, such as "J" lead shape 34 shown in Figs. 5 and 8.

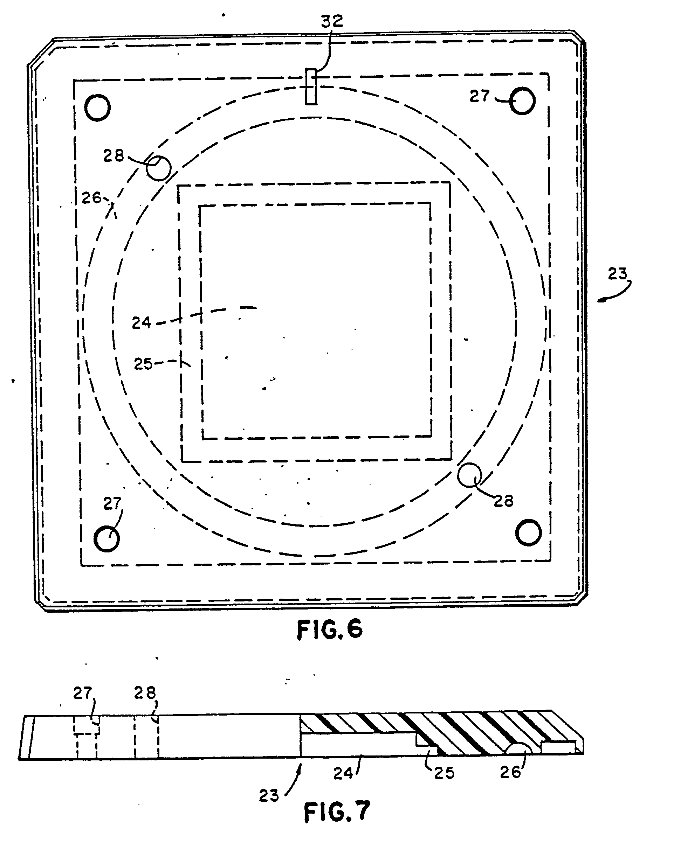

Next, cover 23 is placed on support 11, posts 22 fitting into holes 27. Holes 27 are counterbored about half-way through as shown in Fig. 7, for example, to 1,1 mm diameter from 0,84 mm diameter. Posts 27 extend somewhat in the counterbores of holes 27, thereby providing the means for securing cover 23 to support 11 by heat-flowing the extending upper ends of posts 27, as raised portions 16 and 30 are heat-flowed. Next, a sealant, for example, a silicone gel, is pumped into holes 28 to completely fill troughs 17 and 28 as well as holes 28. The sealant should be sufficiently adherent and flexible, after curing, to maintain a hermetic seal through normal thermal cycling requirements. If desired, assembly of cover 23 and sealing of trough 17 and 28 can be performed in an atmosphere having greater heat dissipation characteristics than air such as helium. This atmosphere will be sealed in the recesses in which chip 31 is disposed. To complete the package, a lead identifier 32 may be used, as shown in Fig. 8, and rails 19 and tie bars 20 are removed at score lines 33.

The finished unit, shown in Fig. 8, has overall measurements, including formed leads 34, of 25,1 mm square by 4,4 mm high.

This invention is also applicable to lead frames made other than by stamping, such as etching or chemical forming. There, a significant advantage to the use of segments as per this invention is a substantial reduction in tooling cost.

## Claims

1. A packaged IC chip comprising a lead frame support (11) made of electrically insulating material and having a pad area (12) at the center thereof, said pad area (12) being square or rectangular, an IC chip (31) disposed on said pad area (12), lead frame means (1) disposed around said pad area (12) and comprising a plurality of spaced-apart leads (4) the inner ends (5) of which converge towards the IC chip (31) a cover (23) made of electrically insulating material disposed on and mating with said support (11), and a sealant material encircling the IC chip (31) between the support (11) and the cover (23), the sealant material sealing the IC chip (31) from the environment, characterized by said lead frame means comprising a plurality of individual lead frame segments (1) disposed around said pad area (12), first raised spaced-apart projections (14) being provided proximate the periphery of said pad area (12) on all four sides thereof, the spaces between the projections (14) defining slots (18) each one of said leads (4) being positioned in one of said slots (18).

2. The packaged IC chip of claim 1 wherein there is a recessed area (25) in said cover (23) to accommodate said raised spaced-apart projections (14).

3. The packaged IC chip of claim 1 or 2 wherein the sealant material is disposed in a trough (17, 26) encircling the IC chip (31).

4. The packaged IC chip of claim 1, 2 or 3 wherein the cover (23) mates with the support (11) by means of posts (22) on one part (11; 23) thereof fitting into holes (27) in the other part (23; 11).

5. The packaged IC chip of claim 4, wherein the cover (23) and support (11) are made of thermoplastic material and wherein the cover (23) can be secured to the support (11) by heat-flowing the ends of the posts (22).

## Patentansprüche

1. In einem Gehäuse montiertes integriertes Schaltungsplättchen, enthaltend einen Leiterrahmenträger (11), der aus einem elektrisch isolierenden Material besteht und eine Anschlußfläche (12) in der Mitte aufweist, wobei die Anschlußfläche (12) quadratisch oder rechteckig ist, ein integriertes Schaltungsplättchen (31) auf der Anschlußfläche (12) angeordnet ist, Leiterrahmeneinrichtungen (1) um die Anschlußfläche (12) angeordnet sind und mehrere zueinander beabstandete Leitungen (4) aufweisen, deren innere Enden (5) gegen das integrierte Schaltungsplättchen (31) zusammenlaufen, einen Deckel (23) aus elektrisch isolierendem Material, der auf dem Träger (11) angeordnet ist und zu diesem paßt, und ein Dichtungsmaterial, das das integrierte Schaltungsplättchen (31) zwischen dem Träger (11) und dem Deckel (23) umgibt und das integrierte Schaltungsplättchen (31) gegenüber der Umgebung anschließt, dadurch gekennzeichnet, daß die Leiterrahmeneinrichtung mehrere einzelne Leiterrahmensegmente (1) enthält, die um die Anschlußfläche (12) angeordnet sind, wobei erste erhöhte, im Abstand zueinander angeordnete Vorsprünge (14) nahe dem Umfang der Anschlußfläche (12) an allen vier Seiten derselben vorgesehen sind und die Zwischenräume zwischen den Vorsprüngen (14) Schlitze (18) ausbilden, wobei jeweils einer der genannten Leiter (4) in einem der genannten Schlitze (18) angeordnet ist.

2. In einem Gehäuse montiertes integriertes Schaltungsplättchen nach Anspruch 1, bei dem ein vertiefter Bereich (25) in dem Deckel (23) ausgebildet ist, um die erhöhten, im Abstand zueinander angeordneten Vorsprünge (14) aufzunehmen.

3. In einem Gehäuse montiertes integriertes Schaltungsplättchen nach Anspruch 1 oder 2, bei dem das Dichtungsmaterial in einer Rinne (17, 26) angeordnet ist, die das integrierte Schaltungsplättchen (31) umgibt.

4. In einem Gehäuse montiertes integriertes Schaltungsplättchen nach Anspruch 1, 2 oder 3, bei dem der Deckel (23) auf den Träger (11) mittels Stöpseln (22) an dem einen Teil (11; 23) derselben, die in Löchern (27) in dem anderen Teil (23; 11) sitzen, aufgepaßt ist.

5. In einem Gehäuse montiertes integriertes Schaltungsplättchen nach Anspruch 4, bei dem der Deckel (23) und der Träger (11) aus thermoplastischem Material bestehen und der Deckel (23) an dem Träger (11) durch Wärmeverschmelzen der Enden der Stöpsel (22) gesichert werden kann.

## Revendications

1. Puce à circuit intégré montée dans un boitier comprenant un support cadre (11) des conducteurs réalisé dans un matériau électriquement isolant, et comportant une zone (12) formant semelle en son centre, la dite zone formant semelle (12) étant carrée ou rectangulaire, une puce à circuit intégré (3) disposée sur la dite zone formant semelle, des moyens de cadre des conducteurs (1) disposés autour de la dite zone formant semelle (12) et comprenant une pluralité de conducteurs (4) séparés les uns des autres, dont les extrémités intérieures (5) convergent vers la puce à circuit intégré (31), un couvercle (23) réalisé dans un matériau électriquement isolant disposé sur le dit support (11) et coopérant avec ce dernier, et un matériau de scellement enfermant la puce à circuit intégré (31) entre le support (11) et le couvercle (23), le matériau de scellement isolant la puce à circuit intégré (31) par rapport à son environnement, caractérisée en ce que les dits moyens de cadre conducteur comprennent une pluralité de segments (1) de cadre des conducteurs disposés autour de la dite zone formant semelle (12), des premières projections saillantes séparées les unes des autres étant réalisées à proximité de la périphérie de la dite zone formant semelle (12), sur les quatre côtés de cette dernière, les espaces entre les projections (14) déterminant des fentes (18), chacun des dits conducteurs (4) étant disposé dans l'une des dites fentes (18).

2. Puce à circuit intégré montée dans un boitier selon la revendication 1 caractérisée en ce qu'une zone en retrait (25) est ménagée dans le dit couvercle (23) pour recevoir les dites projections saillantes séparées les unes des autres (14).

3. Puce à circuit intégré montée dans un boitier selon la revendication 1 ou 2 caractérisée en ce que ledit matériau de scellement est disposé dans une rigole (16, 26) entourant la puce à circuit intégré (31).

4. Puce à circuit intégré montée dans un boitier selon la revendication 1, 2 ou 3 caractérisée en ce que le couvercle (23) coopère avec le support (11) au moyen de montants (22) prévus sur l'un deux (11, 23) pénétrant dans des orifices (27) pratiqués dans l'autre (23, 11).

5. Puce à circuit intégré montée dans un boitier selon la revendication 4 caractérisée en ce que le couvercle (23) et le support (11) sont réalisés dans un matériau thermoplastique, et que le dit couvercle (23) peut être fixé au support (11) par chauffage des extrémités des montants (22).

FIG.I

FIG.2

EP 0 163 082 B1

FIG.3

FIG.8

FIG.5

FIG.4

FIG.6

FIG.7